(19) Europäisches Patentamt
European Patent Office
Office européen des brevets

(11) Publication number: **0 301 520 B1**

(12) **EUROPEAN PATENT SPECIFICATION**

(45) Date of publication of patent specification: **07.10.92**

(51) Int. Cl.⁵: **G03F 7/038**

(21) Application number: **88112160.2**

(22) Date of filing: **27.07.88**

(54) **Dry presensitized plate.**

(30) Priority: **31.07.87 JP 192442/87**

(43) Date of publication of application:
**01.02.89 Bulletin 89/05**

(45) Publication of the grant of the patent:
**07.10.92 Bulletin 92/41**

(84) Designated Contracting States:
**DE FR GB**

(56) References cited:
**EP-A- 0 044 220**
**DE-A- 3 623 048**
**DE-A- 3 702 839**
**DE-A- 3 816 211**
**FR-A- 2 316 257**

**PATENT ABSTRACTS OF JAPAN, vol. 10, no. 312 (P-509)[2368], 23rd October 1986;& JP-A-61 123 847**

(73) Proprietor: **Fuji Photo Film Co., Ltd.**
**210 Nakanuma Minamiashigara-shi**
**Kanagawa-ken(JP)**

(72) Inventor: **Kita, Nobuyuki Fuji Photo Film Co., Ltd.**
**4000 Kawashiri Yoshida-cho**
**Haibara-gun Shizuoka-ken(JP)**

(74) Representative: **Patentanwälte Grünecker, Kinkeldey, Stockmair & Partner**
**Maximilianstrasse 58**
**W-8000 München 22(DE)**



Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a dry presensitized plate for use in making a lithographic printing plate requiring no dampening water.

There have been proposed various dry presensitized plates for use in making lithographic printing plates requiring no dampening water, as disclosed for example, in U.S. Patent Nos. 3,677,178, 3,511,178, 3,865,588, 3,894,873 and 4,342,820 and GB Patent No. 1,419,643. Among light-sensitive materials for a positive type presensitized plate requiring no dampening water, there are general types using a photopolymerizable light-sensitive material as disclosed in U.S. Patent No. 3,894,873 and Japanese Patent Publication No. 56-23150, and types using a photodimerizable light-sensitive material as disclosed in GB Patent No. 1,419,643.

In the types using a photopolymerizable light-sensitive layer, an adhesive strength durable against development and printing can be obtained between the silicone rubber layer and the light-sensitive layer, and thus it is generally unnecessary to add an adhesion aid (such as silane coupling agent) for giving the silicone rubber layer an adhesive property with respect to the light-sensitive layer. Further, as the adhesive strength between the silicone rubber layer and the light-sensitive layer can be controlled by light, that is, as the plate making is carried out by photoadhering the silicone rubber layer of the nonimage areas onto the light-sensitive layer and selectively removing only the silicone rubber layer of the image areas (nonexposed areas), adequate development is possible with a very mild developing solution, and the types using a photopolymerizable light-sensitive layer are excellent in image reproduction in the highlight areas which are relatively hard to develop. However, as a silicone rubber layer is adhered onto the light-sensitive layer by light, these types have disadvantages in that they do not provide good image formation of the shadow areas liable to be deficient in light quantity, and that since adequate photoadhesion is not obtained, the image of the shadow areas is liable to be distorted. Further, these types have a disadvantage in that the printing degree (gray scale printing grade) changes greatly with the temperature at the time of exposure to light and with the shelf time between exposure to light and development, and this disadvantage causes a problem, particularly in case of the repeated exposure by a composer.

On the other hand, in types using a photodimerizable light-sensitive layer adequate photoadhesion cannot be obtained, which is different from the case of a photopolymerizable light-sensitive layer, and thus adhesion between the silicone rubber layer and the light-sensitive layer is reinforced by previously adding to the silicone rubber layer a silane coupling agent reactive with both the light-sensitive layer and the silicone rubber layer, as an adhesion aid. Therefore, there has been used a plate making method utilizing the difference in solubility of the light-sensitive layer, namely a plate making method wherein the nonimage area (area exposed to light) light-sensitive layer and the silicone rubber layer on the layer are left as an ink repulsion layer and the image area (area unexposed to light) light-sensitive layer is dissolved and removed together with the silicone rubber layer thereon to obtain image areas. The thus obtained printing plate has an excellent image reproductivity from the highlight areas to the shadow areas. However, since usual photodimerizable light-sensitive resins used for photodimerizable light-sensitive layers have double bonds conjugated with an aromatic ring as a light-sensitive group, they are generally hard polymers having a strong intermolecular strength and have only a poor solubility in solvents. Thus a developing solution having a high organic solvent content and a relatively strong solubilizing power becomes necessary in order to realize a plate making method wherein the development is carried out by dissolving the photodimerizable light-sensitive resin. Further, this type of presensitized plate requiring no dampening water has the characteristic that there is no change of printing degree with time lapse between exposure to light and development and stable plate making is possible.

DE-A-3623048 and EP-A-0044220 disclose dry presensitized plates comprising a support, a photosensitive layer and a silicone rubber layer, the photosensitive layer containing polymers with light-sensitive groups having phenyl groups as substituents.

It is the object of the invention to provide a dry presensitized plate which can be processed with a relatively mild developing solution and from which a lithographic printing plate requiring no dampening water and excellent in image reproductivity can be obtained.

Said object is achieved by a dry presensitized plate for use in making a lithographic printing plate requiring no dampening water comprising a support having provided thereon in order a light-sensitive layer and a silicone rubber layer wherein the light-sensitive layer contains a polymer having at the side chains at least a light-sensitive group represented by the general formula (I),

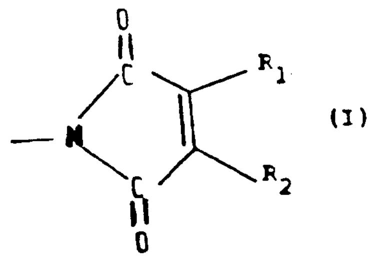

(I)

wherein $R_1$ and $R_2$ each represents an alkyl group,
and the silicone rubber layer comprises as the main component a linear organic polysiloxane having the following repeating unit and a molecular weight of several thousands to several hundred thousands,

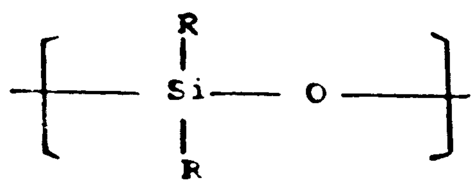

wherein R is an alkyl group having 1 to 10 carbon atoms or a phenyl group.

The dry presensitized plate of the present invention undergoes only a slight change in sensitivity owing to environmental conditions at which it can be processed with a relatively mild developing solution and moreover can provide a lighographic printing plate excellent in image reproductivity.

The dry presensitized plate of the invention must have flexibility to an extent that it can be set in an ordinary printing machine and must be capable of withstanding load during printing. Therefore, examples of typical supports include coated papers, metal plates, plastic films such as polyethylene terephthalate film and rubbers, and composite supports thereof. A primer layer may further be provided by coating on the surface of these substrates for antihalation or other purposes to form a support.

As such primer layers there can be used various light-sensitive polymers exposed to light and hardened before formation of the light-sensitive layers as disclosed in Japanese Patent Application 60-229031, theremohardened epoxy resins as discloses in Japanese Patent Application No. 62-50760 and hardened gelatin layer as disclosed in DE-A-3739801. Further, these primer layers may contain additives such as a dyestuff for antihalation or other purposes, a printing-out agent, and a polymerizable monomer as photoadhesive agents or a photopolymerization initiator. The coating thickness of the primer layer is generally 4 $g/m^2$ to 10 $g/m^2$.

Polymers having at the side chains light-sensitive groups represented by the above general formula (I) as used in the light-sensitive layer in the invention are disclosed, for example, in Japanese Patent Application No. 52-988 (corresponding to US Patent No. 4,079,041), West German Patent No. 2,626,769, European Patent Nos. 21,019 and 3,552, Die Angewandte Makromolekulare Chemie 115 (1983), pp. 163 - 181, Japanese Patent Application Nos. 49-128991 to 49-128993, 50-5376 to 50-5380, 53-5298 to 53-5300, 50-50107, 51-47940, 52-13907, 50-45076, 52-121700, 50-10884 and 50-45087, and West German Patent Nos. 2,349,948 and 2,616,276.

$R_1$ and $R_2$ in the above general formula (I) are preferably alkyl groups having 1 to 4 carbon atoms, particularly preferably methyl groups. These alkyl groups may have one or more substituents.

Among the polymers having at the side chains light-sensitive groups represented by the above general formula (I), there are preferably used in the invention those having at the side chains an average of 2 or more light-sensitive groups represented by the general formula (I) per molecule and having an average molecular weight of 1,000 or more, particularly 10,000 to 500,000. Such a polymer can easily be prepared by copolymerizing a monomer represented by the general formula (II), (III), (IV):

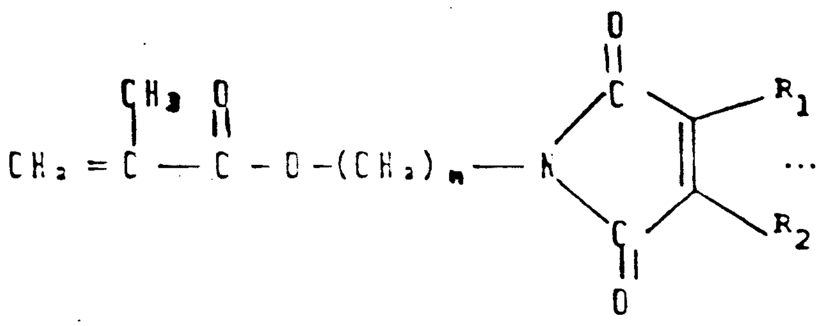

··· (II)

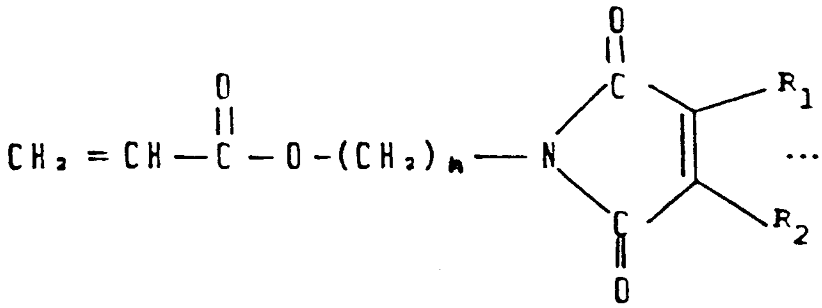

··· (III)

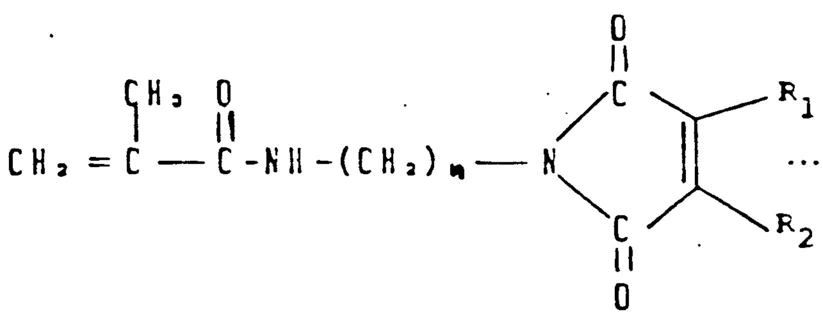

··· (IV)

wherein $R_1$ and $R_2$ have the same meaning as stated above and n represents an integer of, preferably, 1 to 6, with at least one other copolymerization monomer in a molar ratio of 95/5 to 30/70, preferably 90/10 to 70/30.

When a carbon-carbon double bond-containing monomer having an acid group such as a carboxylic group is used as such other copolymerization monomer, the resulting polymer is soluble in a alkali water and the use of a developing solution using an aqueous solvent becomes possible and is advantageous in view of preventing environmental pollution. A light-sensitive layer which can be perfectly developed with city water can be made up by using the thus synthesized polymer having an acid group in a state neutralized with an alkali such as sodium hydroxide or potassium hydroxide. Examples of copolymerizable monomers having an acid group include vinyl monomers having a carboxyl group such as acrylic acid and methacylic acid, and carbon-carbon double bond-containing organic acid anhydrides such as maleic anhydride and itaconic anhydride.

Preferable polymers having at the side chains a light-sensitive group represented by the general formula (I) include copolymers of N-[2-(methacryloyloxy)ethyl]-2, 3-dimethylmaleimide with methacrylic acid or acrylic acid, namely a vinyl monomer having an alkali soluble group as disclosed in Die Angewandte Makromolekulare Chemie 128 (1984), pp. 71 to 91. Further, multi-component copolymers obtained by the above copolymerization further in the presence of a vinyl monomer different from the above vinyl monomer are also preferable.

As the above polymers used in the invention, it is desirable to use those having a molecular weight of 1,000 or more, preferably 10,000 to 500,000, particularly preferably 20,000 to 300,000. The amount of the above polymers to be added to the light-sensitive layer is 10 to 95 weight % (hereinafter abridged as %), preferably 50 to 99%.

A sensitizing agent which can sensitize the above light-sensitive polymer may be added to the light-sensitive layer used in the invention according to necessity.

Specific examples of such sensitizing agents include benzoin, benzoin methyl ether, benzoin ethyl

ether, 2,2-dimethoxy-2-phenylacetophenone, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9,10-anthraquinone, xanthone, 2-methylxanthone, 2-methoxyxanthone, dibenzalacetone, p-(dimethylamino)phenyl styryl ketone, p-(dimethylamino)phenyl p-methylstyryl ketone, benzophenone, p-(dimethylamino)benzophenone (or Michler's ketone), p-(diethylamino)benzophenone, benzanthrone.

There may further be used as sensitizing agents thioxanthone derivatives such as 2-chlorothioxanthone, 2-isopropylthioxanthone, dimethylthioxanthone and ethyl 7-methylthioxanthone-3-carboxylate; substituted thioxanthones as disclosed in West Germany Patent Nos. 3,018,891 and 3,117,568, European Patent No. 33,730 and GB Patent No. 2,075,506; and compounds represented by the following general formula (V)

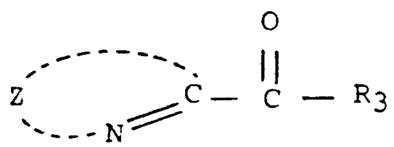

( V )

wherein Z is a nonmetal atomic group necessary for forming a heterocyclic nucleus containing one or more nitrogen atom. Examples of the heterocyclic nucleus containing a nitrogen atom and formed with Z are thiazoles such as benzothiazole, α-naphthothiazole and β-naphthothiazole; oxazoles such as benzoxazole and β-naphthoxazole; selenazoles such as benzoselenazole; imidazoles such as imidazole and benzimidazole; isoindoles such as 3,3-dimethylindolenine; quinolines such as quinoline and isoquinoline; diazoles such as 1,3,4-oxadiazole, 1,3,4-thiadiazole and 1,3,4-selenadiazole; and triazoles such as 1,2,4-triazole; and further pyrazine, quinoxaline, S-triazine and phenanthridine. These heterocyclic nuclei containing a nitrogen atom and formed with Z may have a substituent. Such substituents include an alkyl group having 1 to 6 carbon atoms such as a methyl or a ethyl group; an alkoxy group having 1 to 6 carbon atoms such as a methoxy or an ethoxy group; a halogen atom such as a chlorine or a bromine atom; a cyano group; an amino group; an amino group substituted with an alkyl group having 1 to 4 carbon atoms such as a dimethylamino group; a carboalkoxy group having an alkyl group of 1 to 4 carbon atoms such as a carbomethoxy group; a substituted or unsubstituted aryl group having 6 to 10 carbon atoms such as a phenyl, a p-methoxyphenyl or a p-chlorophenyl group.

When $R_3$ is an aryl group, it represents a monocyclic or polycyclic aryl group having 6 to 14 carbon atoms such as a phenyl or naphthyl group. When $R_3$ is a substituted aryl group, examples of the substituent are an alkyl group having 1 to 6 carbon atoms, an alkoxy group having 1 to 6 carbon atoms, an aryl group having 6 to 10 carbon atoms, an amino group, an amino group substituted with an alkyl group having 1 to 6 carbon atoms, a halogen atom such as a fluorine, chlorine or bromine atom. The alkyl group used as the above substituent may further have a substituent such as an alkoxy group having 1 to 2 carbon atom, i.e. a methoxy or ethoxy group or a halogen atom such as a chlorine atom.

Preferred examples of the substituent in these substituted aryl groups include an alkyl group having 1 to 4 carbon atoms such as a methyl or ethyl group; an alkoxy group having 1 to 4 carbon atoms such as a methoxy or ethoxy group; an amino group substituted with an alkyl group having 1 to 4 carbon atoms such as a dimethylamino or diethylamino group; and a halogen atom such as a fluorine, chlorine or bromine atom.

When $R_3$ is a substituted or unsubstituted heterocyclic group, the heterocycle is a monocyclic or polycyclic compound containing at least one of a nitrogen atom, oxygen atom and sulfur atom, and preferably a 5- or 6-membered heterocyclic aromatic compound such as furan, pyrrole or pyridine.

Examples of the substituents of the substituted heterocyclic group include substituents similar to those enumerated regarding the above substituted aryl group.

The amount of these sensitizing agents to be added is preferably 0.5 to 20%, more preferably 3 to 10%, based on the total composition (namely, whole light-sensitive layer).

It is preferably that a thermopolymerization inhibitor be added to the light-sensitive layer besides the above components. Further, a dyestuff or a pigment for coloring of the light-sensitive layer or a pH-indicator as a printing-out agent can be added to the light-sensitive layer, if desired.

The thickness of the thus explained light-sensitive layer is preferably as thin as possible when a plate making method is adopted wherein the light-sensitive layer and the silicone rubber layer of the image areas are removed in the development step after imagewise exposure to light, but it is generally desirable that the thickness be 1.5 µm or less and most desirable that it be selected from the range of 0.1 to 1 µm

The silicone rubber layer used in the invention comprises as the main component a linear organic polysiloxane having the following repeating unit and a molecular weight of several thousands to several hundred thousands:

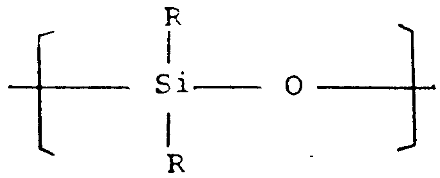

wherein R is an alkyl group having 1 to 10 carbon atoms or a phenyl group. It is preferable that 60% or more of the R groups be methyl groups. This type of linear organic polysiloxane is generally converted to a crosslinked silicone rubber by adding a reactive crosslinking agent. Crosslinking agents used for so-called room temperature (low temperature)-hardened type silicone rubbers include, for example, silanes which may have a monovalent organic group bonded with the silicon atom, such as acetoxysilane, ketoximesilane, aminoxysilane, amidosilane, alkoxysilane and hydroxysilane; siloxanes which are low polymerization degree condensates of these silanes; and organo-hydrogenpolysiloxanes. Further, a reactive silane compound having an allylisocyanurate group, a reactive silane compound having an aminoalkyl group, or the like may be added to the silicone rubber composition in order to enhance the adhesive strength between the light-sensitive layer and the silicone rubber layer and further in order to prevent lowering of the adhesive strength between the layers even after lapse of a long time.

The amount of the above reactive crosslinking agents and/or reactive silane compounds to be added to the silicone rubber layer is preferably 0.05 to 10%, more preferably 0.1 to 5%. Further, these adhesive components can be used in a mixed state.

Further, it is general to also add a small amount of an organotin compound to the silicone rubber layer as a catalyst.

It is preferable on the one hand for the silicone rubber layer to be as thin as possible in view of tone reproducibility, while on the other hand the layer requires some extent of thickness in view of printing durability and prevention of background contamination. Thus, it is generally appropriate for the thickness to be 0.5 to 10 μm, desirably 1.0 μm to 3.0 μm.

Further, it is possible to provide, according to necessity, a film or the like of one of the following plastics as a protective membrane on the presensitized plate of the invention. Such plastics include polyethylene, polypropylene, polyvinyl chloride, polyvinylidene, chloride, polyvinyl alcohol, polyethylene terephthalate and cellophane.

The dry presensitized plate of the invention is exposed to light through a transparent pattern, and then developed with a developing solution capable of dissolving or swelling the light-sensitive layer of the image areas or with a developing solution capable of swelling the silicone rubber layer.

Whether the development results in both the light-sensitive layer and the silicone rubber layer thereon of the image areas being removed or in only the silicone rubber layer of the image areas being removed can be controlled by controlling the intensity of the developing solution.

As developing solutions in the invention there can be used conventional ones known as developing solutions of presensitized plates not requiring dampening water. Suitable developing solutions include those prepared, for example, by adding one of the following polar solvents to an aliphatic hydrocarbon (hexane, heptane, or Isopar E, H or G (trademarks of aliphatic hydrocarbons manufactured by EXXON CHEMICAL CO.), or gasoline, kerosene); an aromatic hydrocarbon (toluene, xylene); or a halogenated hydrocarbon (trichlene):

Alcohols (methanol, ethanol, benzyl alcohol)

Ethers (methylcellosolve, ethylcellosolve, butylcellosolve, methylcarbitol, ethylcarbitol, butylcarbitol, dioxane)

Ketones (acetone, methyl ethyl ketone)

Esters (ethyl actate, methylcellosolve acetate, cellosolve acetate, carbitol acetate).

The developing solutions comprising the above-mentioned organic solvent can be used in the form of a mixture with water or they may be solubilized in water with a surface active agent, and in some case a developing solution solely consisting of city water can be used as the developing solution.

Further, dyes such as Crystal Violet and Astrazone Red can be added to the developing solution to color the image at the time of the developing.

The development can be carried out by a known method, for example, by rubbing the plate surface with

a developing pad impregnated with such a developing solution or by pouring such a developing solution on the plate surface and rubbing it with a development brush. Thereby, the silicone rubber layer and light-sensitive layer of the image areas are removed to expose the surface of the support or primer layer which serves as an ink-receiving area; or only the silicone rubber layer of the image areas is removed to expose the light-sensitive layer which serves as the ink-receiving area.

The dry presensitized plate of the invention requiring no dampening water has a layer composition comprising a light-sensitive layer and a silicone rubber layer formed in this order on a support, and the light-sensitive layer contains a polymer having at the side chains at least a light-sensitive group represented by the aforementioned general formula (I). Therefore, such a dry presensitized plate undergoes only a small environment-induced sensitivity change at printing-out, can be processed with a relatively mild developing solution, and moreover, can provide a lithographic printing plate requiring no dampening water and excellent in image reproductivity.

The invention is further described by examples.

Example 1

The following composition for a primer layer was applied in an amount of 4.0 g/m$^2$ (based on dry weight) onto a smooth aluminum plate degreased by a conventional method and heated at 100 °C for 2 min to be dried and hardened.

| | |
|---|---|
| Milk casein | 98 weight parts |
| Glyoxal solution (40% aqueous solution, manufactured by WAKO JUNYAKU KOGYO CO., LTD.) | 2 weight parts |
| γ-Glycidoxypropyltri-(β-methoxyethoxy)silane | 3 weight parts |
| 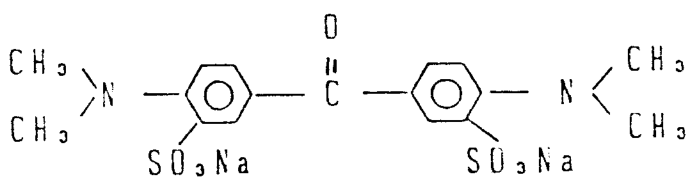 | 5 weight parts |
| Potassium hydroxide | 4 weight parts |
| Pure water | 4000 weight parts |

The aluminum plate having provided thereon the above primer layer was immersed for 1 min in a dyeing solution having the following composition, washed after dyeing and dried at room temperature.

| | |
|---|---|
| 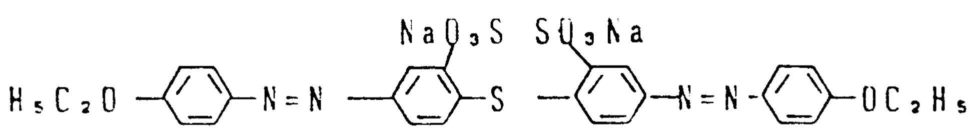 | 1 weight part |
| Pure water | 2000 weight parts |

The following light-sensitive composition was applied in an amount of 1 g/m$^2$ (based on dry weight) onto an aluminum plate having provided thereon the above dyed primer layer, and dried.

| | |
|---|---|
| N-[2-(methacryloyloxy)ethyl]-2,3-dimethylmaleimide/2-hydroxyethyl methacrylate =60/40(weight ratio) copolymer | 90 weight parts |
| Ethyl 7-methylthioxanthone-3-carboxylate | 10 weight parts |
| Propylene glycol monomethyl ether acetate | 1100 weight parts |
| Methyl ethyl ketone | 1100 weight parts |

The following silicone rubber composition was then applied in an amount of 2.0 $g/m^2$ (based on dry weight) onto the above light-sensitive layer, and dried to obtain a hardened silicone rubber layer.

| | |
|---|---|
| Dimethylpolysiloxane having hydroxyl groups at both ends (average molecular weight 600,000) | 100 weight parts |
| Methylhydrogenpolysiloxane having trimethylsilyl groups at both ends (average molecular weight 2,500) | 3.5 weight parts |
| Trimethoxysilylpropyl-3,5-diallyl isocyanurate | 3.3 weight parts |
| Dibutyltin dioctanoate | 3.3 weight parts |
| Isopar G (manufactured by EXXON CHEMICAL CO.) | 2,000 weight parts |

The surface of the thus obtained silicone rubber layer was laminated with a polypropylene film having a thickness of 12 µm and one surface of which was matted to obtain a presensitized plate requiring no dampening water.

A positive film was superposed on this presensitized plate and brought in contact with it in vacuum. After the plate was exposed to light for 30 counts by a FT26V UDNS ULTRA-PLUS FLIP-TOP PLATE MAKER manufactured by NUARC IND. INC., the laminated film was peeled off. The resulting plate was immersed in a developing solution consisting of 90 weight parts of Isopar H (manufactured by EXXON CHEMICAL CO.), 7 weight parts of diethylene glycol monobutyl ether, 3 weight parts of diethylene glycol monoethyl ether and 5 weight parts of diethyl succinate for 1 min, and gently rubbed with a development pad, whereby the light-sensitive layer and silicone rubber layer of the unexposed areas were removed. Thus, a lithographic printing plate requiring no dampening water was obtained wherein the image of the positive film was faithfully reproduced throughout the whole surface.

This plate was set on a HEIDELBERG GTO printing machine from which the dampening water-supplying apparatus was removed and subjected to printing using TOYO KING ULTRA TUK AQUALESS G SUMI ink (manufactured by TOYO INK CO., LTD.), so that prints exhibiting a faithful image reproductivity were obtained.

Example 2

A light-sensitive primer solution having the following composition was applied onto a degreased aluminum plate having a thickness of 0.3 mm, and dried at 120 °C for 1 min. The coated weight after drying was 4 $g/m^2$.

| | |
|---|---|
| EPIKOTE 1255-HX-30 (30% solution) (condensate of bisphenol A and epichlorohydrin manufactured by YUKA SHELL EPOXY CO., LTD) | 5 g |
| TAKENATE D-110N (75% solution) (polyfunctional isocyanate compound manufactured by TAKEDA CHEMICAL INDUSTRIES CO., LTD.) | 1.5 g |
| Pentaerythritol triacrylate | 1 g |
| Ethyl 7-methylthioxanthone-3-carboxylate | 0.5 g |
| Victoria Pure Blue BOH | 0.005 g |
| 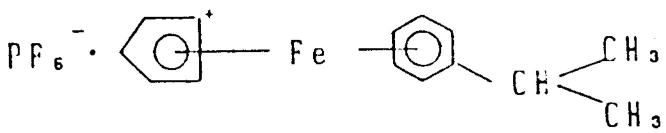 | 0.01 g |
| Methyl ethyl ketone | 30 g |
| Propylene glycol monomethyl ether acetate | 30 g |

A water soluble light-sensitive solution having the following composition was then applied onto the resulting plate and dried at 100 ° C for 2 min. The coated dry weight was 1.0 g/$m^2$.

| | |
|---|---|
| Sodium salt (10% aqueous solution) of copolymer of N-[2-(methacryloyloxy)ethyl]-2,3-dimethylmaleimide/2-hydroxyethyl methacrylate/methacrylic acid = 70/20/10 (weight ratio) | 50 g |
| Water | 40 g |
| Methanol | 10 g |

The following silicone rubber composition was then applied in an amount of 1.2 g/$m^2$ (based on dry weight) onto the light-sensitive layer and dried to obtain a hardened silicone rubber layer.

| | |
|---|---|
| Dimethylpolysiloxane having hydroxyl groups at both ends (average molecular weight 600,000) | 100 weight parts |
| Methyltriacetoxysilane | 3.5 weight parts |
| Trimethoxysilylpropyl-3,5-diallyl isocyanurate | 3.3 weight parts |
| Dibutyltin dioctanoate | 0.3 weight parts |
| Isopar G (manufactured by EXXON CHEMICAL CO.) | 2,000 weight parts |

The surface of the thus obtained silicone rubber layer was laminated with a polypropylene film having a thickness of 12 µm, one surface of which had been matted to obtain a dry presensitized plate requiring no dampening water.

This dry presensitized plate was imagewise exposed to light in the same manner as in Example 1, and immersed in 50 ° C warm water for 30 s. The plate surface was rubbed with a sponge for 30 s to remove the silicone rubber layer and light-sensitive layer of the unexposed areas, whereby a lithographic printing plate

requiring no dampening water was obtained wherein the image of the positive film was faithfully reproduced throughout the whole surface.

Example 3

A water soluble light-sensitive solution having the following composition was applied onto an aluminum support having provided thereon 4 g/m$^2$ primer layer as used in Example 2, and dried at 100 ° C for 2 min. The applied dry weight was 1.0 g/m$^2$.

| | |
|---|---|
| Sodium salt (10% aqueous solution) of copolymer of N-[2-(methacryloyloxy)ethyl]-2,3-dimethylmaleimide/2-hydroxyethyl methacrylate/methacrylic acid = 70/20/10 (weight ratio) | 50 g |
| Colloidal silica (20% aqueous solution) | 3 g |
| Water | 40 g |
| Methanol | 10 g |

A silicone solution having the following composition was applied onto this light-sensitive layer, and dried at 120 ° C for 1 min. The applied dry weight was 1.2 g/m$^2$.

Dimethylpolysiloxane (Molecular weight about 100,000) 30 g

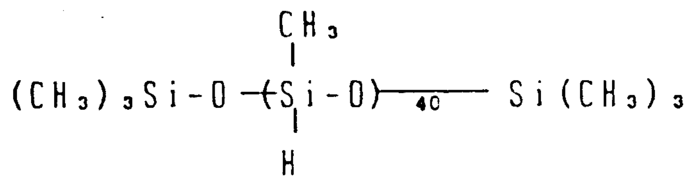 0.3 g

$H_2N(CH_2)_2NH(CH_2)_3Si(OCH_3)_3$ 0.3 g

Dibutyltin acetate 0.1 g

Isopar G (petroleum solvent) 180 g

The thus prepared plate was laminated with polyethylene terephthalate film having a thickness of 8 µm to prepare a presensitized plate.

A positive film was brought in contact with this presensitized plate. The plate was then exposed to light and water-developed in the same manner as in Example 2 to remove the silicone rubber layer and the light-sensitive layer of the unexposed areas. The primer layer of the unexposed areas alone was then dyed with the following dyeing solution to obtain a lithographic printing plate requiring no dampening water and excellent in image reproductivity.

| | |
|---|---|
| Benzyl alcohol | 5 g |
| Water | 95 g |
| Victoria Pure Blue BOH | 2 g |
| Nonionic surfactant | 2 g |

Example 4

After the imagewise exposure to light in Example 1, the laminated film was peeled off. The resulting plate was immersed in a developing solution consisting of 10 weight parts of benzyl alcohol, 3.8 weight parts of sodium alkylnaphthalene sulfonate and 80 weight parts of water for one minute, and gently rubbed with a development pad to remove the light-sensitive layer and silicone rubber layer of the unexposed

areas. Thus there was obtained a lithographic printing plate requiring no dampening water wherein the image of the positive film was faithfully reproduced throughout the whole surface of the printing plate.

## Claims

1. A dry presensitized plate for use in making a lithographic printing plate requiring no dampening water comprising a support having provided thereon in order a light-sensitive layer and a silicone rubber layer wherein the light-sensitive layer contains a polymer having at the side chains at least a light-sensitive group represented by the general formula (I):

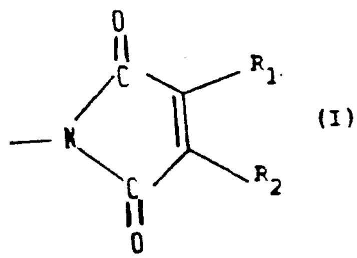

(I)

wherein $R_1$ and $R_2$ each represents an alkyl group,
and the silicone rubber layer comprises as the main component a linear organic polysiloxane having the following repeating unit and a molecular weight of several thousands to several hundred thousands:

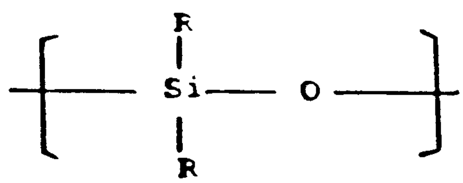

wherein R is an alkyl group having 1 to 10 carbon atoms or a phenyl group.

2. The dry presensitized plate of claim 1, wherein $R_1$ and $R_2$ are substituted or unsubstituted alkyl groups having 1 to 4 carbon atoms.

3. The dry presensitized plate of claim 1, wherein the polymer has at the side chains an average of 2 or more light-sensitive groups represented by the general formula (I) per molecule and hag an average molecular weight of 1,000 or more.

4. The dry presensitized plate of claim 1, wherein the polymer is a copolymer obtained by copolymerising a monomer represented by the formula (II), (III) or (IV):

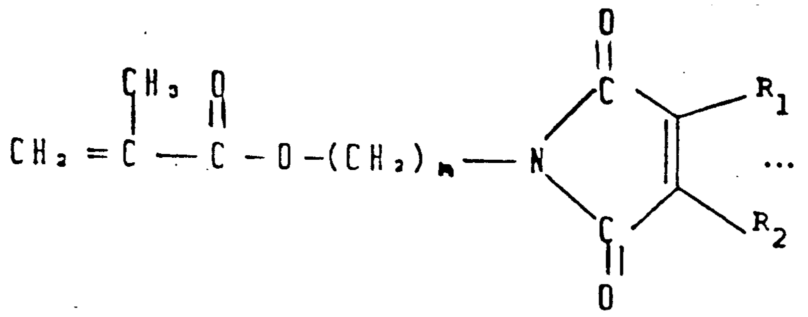

( II )

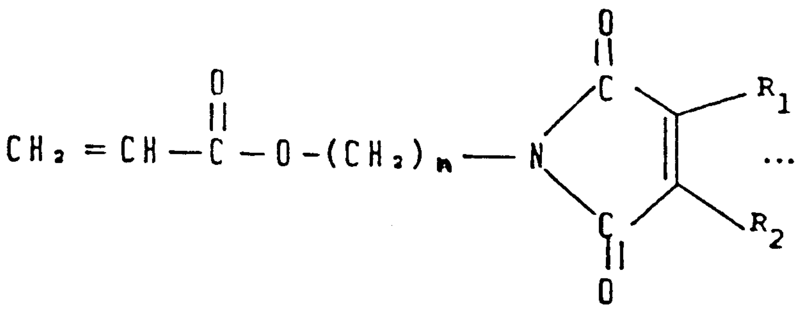

( III )

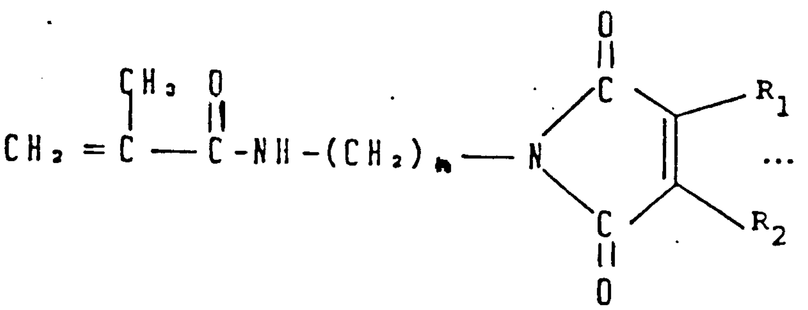

( IV )

wherein $R_1$ and $R_2$ have the same meanings as in the general formula (I), and n represents an integer, preferably of 1 to 6, with at least one other copolymerisable monomer in a molar ratio of 95/5 to 30/70.

**5.** The dry presensitized plate of claim 4, wherein the other copolymerisable monomer is a carboxyl group-containing vinyl monomer or a carbon-carbon double bond-containing organic acid anhydride.

**6.** The dry presensitized plate of claim 5, wherein the carboxy group-containing vinyl monomer is acrylic acid or methacrylic acid.

**7.** The dry presensitized plate of claim 4, wherein the polymer is a copolymer of N-(2-(methacryloyloxy)-ethyl)-2,3-dimethylmaleimide with methacrylic acid or acrylic acid.

**8.** The dry presensitized plate of claim 1, wherein the amount of the polymer to be added to the light-sensitive layer is 10 to 99 weight %.

**9.** The dry presensitized plate of claim 1, wherein the light-sensitive layer contains a sensitizing agent for the polymer.

**10.** The dry presensitized plate of claim 9, wherein the amount of the sensitizing agent to be added to the light-sensitive layer is 0.5 to 20%.

**11.** The dry presensitized plate of claim 1, wherein the thickness of the light-sensitive layer is 1.5 μm or less.

**12.** The dry presensitized plate of claim 1, wherein a primer layer is provided on the support.

**13.** The dry presensitized plate of claim 12, wherein the thickness of the primer layer is 4 to 10 g/m$^2$.

**14.** The dry presensitized plate of claim 1, wherein the silicone rubber layer further contains a reactive crosslinking agent and/or a reactive silane compound each in an amount of 0.05 to 10%.

**15.** The dry presensitized plate of claim 1, wherein the thickness of the silicone rubber layer is 0.5 to 10 μm.

**Patentansprüche**

**1.** Trockene, vorsensibilisierte Platte zur Verwendung bei der Herstellung einer lithographischen Druckplatte, die kein Befeuchtungswasser erfordert, umfassend einen Träger mit einer lichtempfindlichen Schicht und einer Silikonkautschukschicht, die in dieser Reihenfolge angeordnet sind, worin die lichtempfindliche Schicht ein Polymer enthält, das an den Seitenketten wenigstens eine lichtempfindliche Gruppe, dargestellt durch die allgemeine Formel (I):

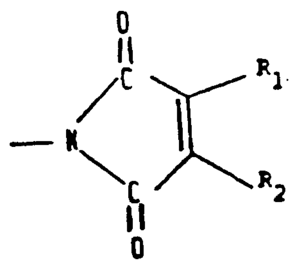

(I) (I)

aufweist, worin $R_1$ und $R_2$ jeweils eine Alkylgruppe bedeuten,
und die Silikonkautschukschicht als Hauptkomponente ein lineares organisches Polysiloxan mit der folgenden wiederkehrenden Einheit und einem Molekulargewicht von mehreren 1000 bis mehreren 100000

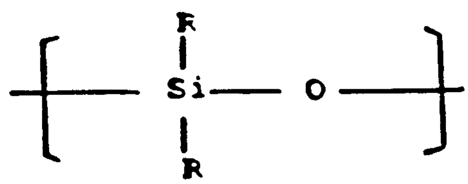

umfaßt, worin R eine Alkylgruppe mit 1 bis 10 Kohlenstoffatomen oder eine Phenylgruppe ist.

**2.** Trockene, vorsensibilisierte Platte nach Anspruch 1, worin $R_1$ und $R_2$ substituierte oder unsubstituierte Alkylgruppen mit 1 bis 4 Kohlenstoffatomen sind.

**3.** Trockene, vorsensibilisierte Platte nach Anspruch 1, worin das Polymer an den Seitenketten durchschnittlich 2 oder mehr lichtempfindliche Gruppen, dargestellt durch die allgemeine Formel (I), pro Molekül besitzt und ein durchschnittliches Molekulargewicht von 1000 oder mehr aufweist.

**4.** Trockene, vorsensibilisierte Platte nach Anspruch 1, worin das Polymer ein Copolymer, erhalten durch Copolymerisieren eines Monomers, dargestellt durch die Formel (II), (III) oder (IV):

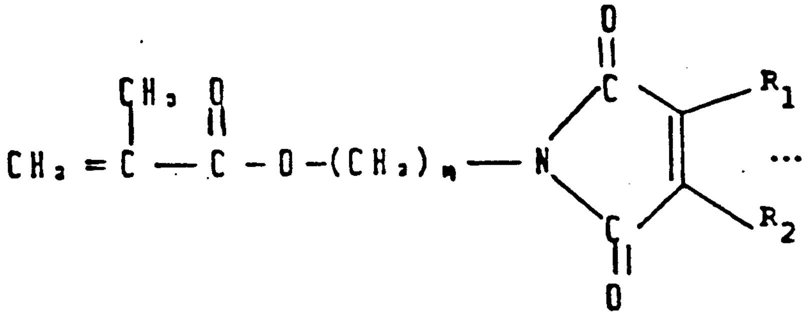 ... (II)

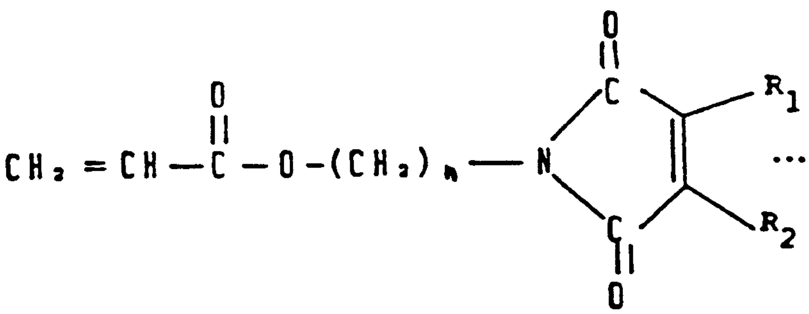 ... (III)

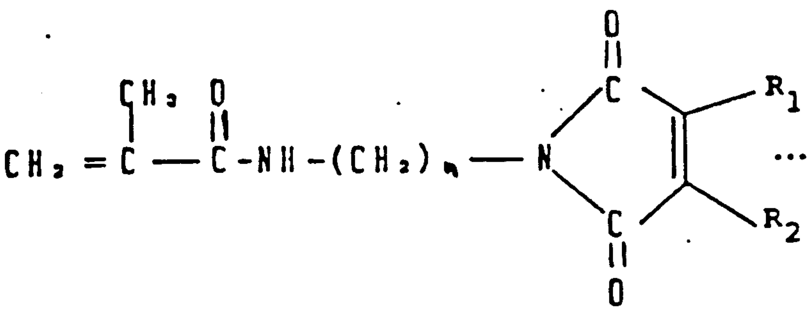 ... (IV)

worin $R_1$ und $R_2$ die gleiche Bedeutung wie in der allgemeinen Formel (I) besitzen und n eine ganze Zahl, vorzugsweise 1 bis 6, bedeutet, mit wenigstens einem anderen copolymerisierbaren Monomer in einem Molverhältnis von 95/5 bis 30/70, ist.

**5.** Trockene, vorsensibilisierte Platte nach Anspruch 4, worin das andere copolymerisierbare Monomer ein carboxylgruppenhaltiges Vinylmonomer oder ein eine Kohlenstoff-Kohlenstoff-Doppelbindung enthaltendes organisches Säureanhydrid ist.

**6.** Trockene, vorsensibilisierte Platte nach Anspruch 5, worin das carboxylgruppenhaltige Vinylmonomer Acrylsäure oder Methacrylsäure ist.

**7.** Trockene, vorsensibilisierte Platte nach Anspruch 4, worin das Polymer ein copolymer von N-(2-(Methacryloyloxy)ethyl)-2,3-dimethylmaleimid mit Methacrylsäure oder Acrylsäure ist.

**8.** Trockene, vorsensibilisierte Platte nach Anspruch 1, worin die Menge des Polymers, die der lichtempfindlichen Schicht zugegeben wird, 10 bis 99 Gew.-% beträgt.

**9.** Trockene, vorsensibilisierte Platte nach Anspruch 1, worin die lichtempfindliche Schicht ein Sensibilisierungsmittel für das Polymer enthält.

**10.** Trockene, vorsensibilisierte Platte nach Anspruch 9, worin die Menge des Sensibilisierungsmittels, das der lichtempfindlichen Schicht zugegeben wird, 0,5 bis 20% beträgt.

**11.** Trockene, vorsensibilisierte Platte nach Anspruch 1, worin die Dicke der lichtempfindlichen Schicht 1,5

µm oder weniger beträgt.

12. Trockene, vorsensibilisierte Platte nach Anspruch 1, worin eine Grundierschicht auf dem Träger vorgesehen ist.

13. Trockene, vorsensibilisierte Platte nach Anspruch 12, worin die Dicke der Grundierschicht 4 bis 10 $g/m^2$ beträgt.

14. Trockene, vorsensibilisierte Platte nach Anspruch 1, worin die Silikonkautschukschicht weiterhin ein reaktives Vernetzungmittel und/oder eine reaktive Silanverbindung, jeweils in einer Menge von 0,05 bis 10%, enthält.

15. Trockene, vorsensibilisierte Platte nach Anspruch 1, worin die Dicke der Silikonkautschukschicht 0,5 bis 10 µm beträgt.

## Revendications

1. Une plaque présensibilisée sèche à utiliser dans la fabrication d'une plaque d'impression lithographique n'ayant pas besoin d'être humectée par l'eau, comprenant un support portant, dans cet ordre, une couche photosensible et une couche de caoutchouc de silicone, caractérisée en ce que la couche photosensible contient un polymère ayant dans les chaînes latérales au moins un groupe photosensible représenté par la formule générale (I) :

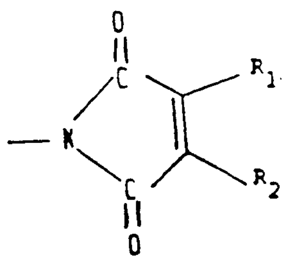

(I)   (I)

dans laquelle $R_1$ et $R_2$ représentent chacun un groupe alkyle et en ce que la couche de caoutchouc de silicone comprend comme composant principal un polysiloxanne organique linéaire ayant des motifs récurrents de formule suivante :

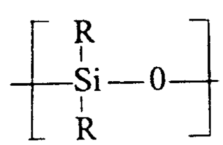

dans laquelle R est un groupe alkyle en $C_1$-$C_{10}$ ou un groupe phényle et un poids moléculaire de plusieurs milliers à plusieurs centaines de mille.

2. La plaque présensibilisée sèche selon la revendication 1, caractérisée en ce que $R_1$ et $R_2$ sont des groupes alkyles en $C_1$-$C_4$ substitués ou non.

3. La plaque présensibilisée sèche selon la revendication 1, caractérisée en ce que le polymère a dans les chaînes latérales une moyenne de deux groupes photosensibles ou plus représentés par la formule générale (I) par molécule et en ce qu'il a un poids moléculaire moyen de 1 000 ou plus.

4. La plaque présensibilisée sèche selon la revendication 1, caractérisée en ce que le polymère est un copolymère obtenu en copolymérisant un monomère représenté par l'une des formules (II), (III) et (IV) :

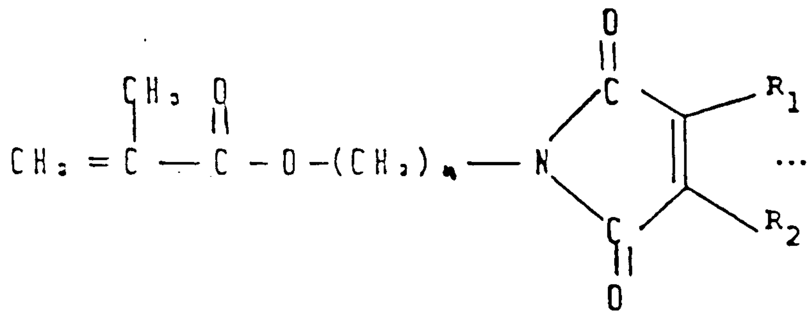 ... (II)

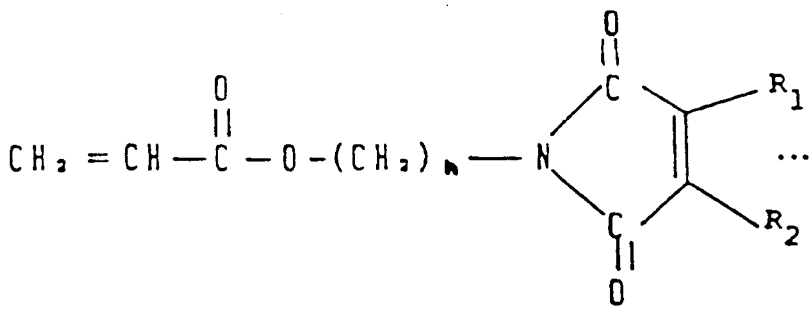 ... (III)

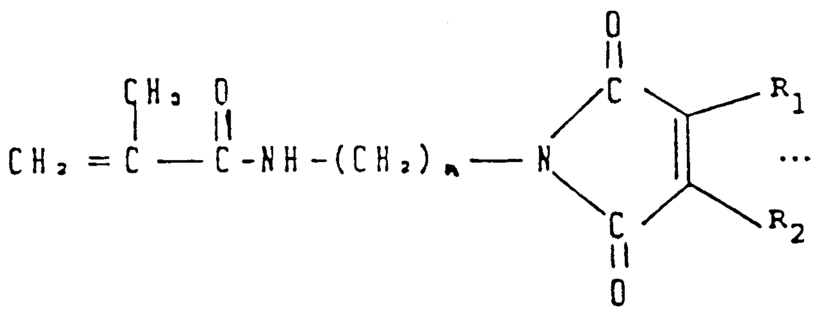 ... (IV)

dans lesquelles $R_1$ et $R_2$ ont les mêmes significations que dans la formule générale (I) et n représente un entier, de préférence de 1 à 6, avec au moins un autre monomère copolymérisable dans un rapport molaire de 95/5 à 30/70.

**5.** La plaque présensibilisée sèche selon la revendication 4, caractérisée en ce que l'autre monomère copolymérisable est un monomère vinylique contenant un groupe carboxyle ou un anhydride d'acide organique contenant une double liaison carbone-carbone.

**6.** La plaque présensibilisée sèche selon la revendication 5, caractérisée en ce que le monomère vinylique contenant un groupe carboxy est l'acide acrylique ou l'acide méthacrylique.

**7.** La plaque présensibilisée sèche selon la revendication 4, caractérisée en ce que le polymère est un copolymère de N-(2-(méthacryloyloxy)éthyl)-2,3-diméthylmaléimide avec l'acide méthacrylique ou l'acide acrylique.

**8.** La plaque présensibilisée sèche selon la revendication 1, caractérisée en ce que la quantité du polymère à ajouter à la couche photosensible est de 10 à 99 % en poids.

**9.** La plaque présensibilisée sèche selon la revendication 1, caractérisée en ce que la couche photosensible contient un agent sensibilisateur pour le polymère.

**10.** La plaque présensibilisée sèche selon la revendication 9, caractérisée en ce que la quantité de l'agent sensibilisateur à ajouter à la couche photosensible est de 0,5 à 20 %.

**11.** La plaque présensibilisée sèche selon la revendication 1, caractérisée en ce que l'épaisseur de la couche photosensible est de 1,5 µm ou moins.

**12.** La plaque présensibilisée sèche selon la revendication 1, caractérisée en ce que le support porte une couche primaire.

**13.** La plaque présensibilisée sèche selon la revendication 12, caractérisée en ce que l'épaisseur de la couche primaire est de 4 à 10 $g/m^2$.

**14.** La plaque présensibilisée sèche selon la revendication 1, caractérisée en ce que la couche de caoutchouc de silicone contient en outre un agent réticulant réactif et/ou un composé silane réactif, chacun en quantité de 0,05 à 10 %.

**15.** La plaque présensibilisée sèche selon la revendication 1, caractérisée en ce que l'épaisseur de la couche de caoutchouc de silicone est de 0,5 à 10 $\mu m$.